Europäisches Patentamt

European Patent Office

Office européen des brevets

(11) Veröffentlichungsnummer: **0 293 846**

**A1**

## (12) EUROPÄISCHE PATENTANMELDUNG

(21) Anmeldenummer: 88108724.1

(22) Anmeldetag: 31.05.88

(51) Int. Cl.⁴: **H01L 29/78 , H01L 29/10**

(30) Priorität: 05.06.87 DE 3718912

(43) Veröffentlichungstag der Anmeldung:
**07.12.88 Patentblatt 88/49**

(84) Benannte Vertragsstaaten:
**DE FR GB IT**

(71) Anmelder: **Siemens Aktiengesellschaft Berlin und München**
**Wittelsbacherplatz 2**
**D-8000 München 2(DE)**

(72) Erfinder: **Strack, Helmut**
**Speyerer Strasse 6**
**D-8000 München 40(DE)**
Erfinder: **Hertrich, Helmut, Dipl.-Phys.**
**Hirtenanger 1**
**D-8049 Fahrenzhausen-Weng(DE)**

(54) **MIS-Leistunsgstransistor.**

(57) Ein MIS-Leistungstransistor soll im Avalanchefall ohne Zerstörung mit einem Strom betrieben werden können, der möglichst hoch über dem Nennstrom liegt. Dies läßt sich dadurch erreichen, daß das Zellenfeld (Z) von Zellen (14) eines anderen Zellentyps umrandet ist, deren Sourcezonen (3) wenigstens in Richtung zum Rand des Zellenfeldes geringere laterale Abmessungen haben als die Sourcezonen (3) der innenliegenden Zellen (12) des Zellenfeldes. Damit läßt sich der meist am Rand des Zellenfeldes fließende Avalanchstrom erhöhen, ohne daß der parasitäre Bipolartransistor eingeschaltet und der Transistor zerstört wird.

EP 0 293 846 A1

FIG 4

## MIS-Leistungstransistor

Die Erfindung bezieht sich auf einen MIS-Leistungstransistor mit mindestens einem auf einem Halbleiterkörper angeordneten Zellenfeld, das einander parallel geschaltete Zellen eines ersten Zellentyps enthält, die jeweils eine Gatezone, eine in die Gatezone eingebettete Sourcezone und eine beide Zonen kontaktierende Sourceelektrode aufweisen.

Solche MIS-Leistungstransistoren sind allgemeiner Stand der Technik. Häufig besteht die Forderung, solche Transistoren auch im Avalanchefall betreiben zu können, ohne daß sie zerstört werden. Verantwortlich für die Zerstörung bei zu hohen Avalancheströmen ist unter anderem das Einschalten des parasitären Bipolartransistors in den Zellen. Die Praxis hat gezeigt, daß besonders die das Zellenfeld begrenzenden oder an anderen Stellen mit inhomogener Zellenverteilung liegende Zellen durch den Avalanchdurchbruch gefährdet sind. Dies rührt daher, daß hier die Feldstärke wegen der relativ starken Krümmung der Raumladungszone des sperrenden p-Übergangs höher ist. Diese Inhomogenitäten bewirken letzlich über das Einschalten des Bipolartransistors eine lokal überhöhte Stromdichte und die Zerstörung einer oder einiger Zellen des MIS-Leistungstransistors. Damit wird der gesamte MIS-Leistungstransistor unbrauchbar.

Ziel der Erfindung ist es, einen MIS-Leistungstransistor der eingangs erwähnten Art so zu verbessern, daß der Avalanchestrom über den Nennstrom des MIS-Leistungstransistors erhöht werden kann, ohne daß dieser zerstört wird.

Dieses Ziel wird dadurch erreicht, daß das Zellenfeld durch Zellen eines zweiten Zellentyps umrandet ist, daß diese Zellen eine Zone und eine Sourcezone und eine die Zone und die Sourcezone kontaktierende Elektrode haben, daß die Sourcezone zwischen der Elektrode und der zum Rand des Zellenfeldes gewandten Seite der Gatezone geringere laterale Abmessungen hat als die Sourcezonen der Zellen der ersten Zellentyps, und daß die Elektroden der Zellen des zweiten Zellentyps mit den Sourceelektroden der Zellen des ersten Zellentyps elektrisch verbunden sind.

Weiterbildungen sind Gegenstand der Unteransprüche.

Die Erfindung wird anhand einiger Ausführungsbeispiele in Verbindung mit den Figuren 1 bis 7 näher erläutert. Es zeigen:

Figur 1 den prinzipiellen Schnitt durch einen MIS-Leistungstransistor,

Figur 2 die Aufsicht auf einen MIS-Leistungstransistor,

Figur 3 einen Schnitt durch einen realen MIS-Leistungstransistor nach dem Stand der Technik,

Figur 4 und 5 Schnitte durch zwei verschiedene Ausführungsbeispiele gemäß der Erfindung,

Figur 6 und 7 die Aufsicht auf je eine Zelle des zweiten Leitungstyps bei einem MIS-Leistungstransistor gemäß Erfindung.

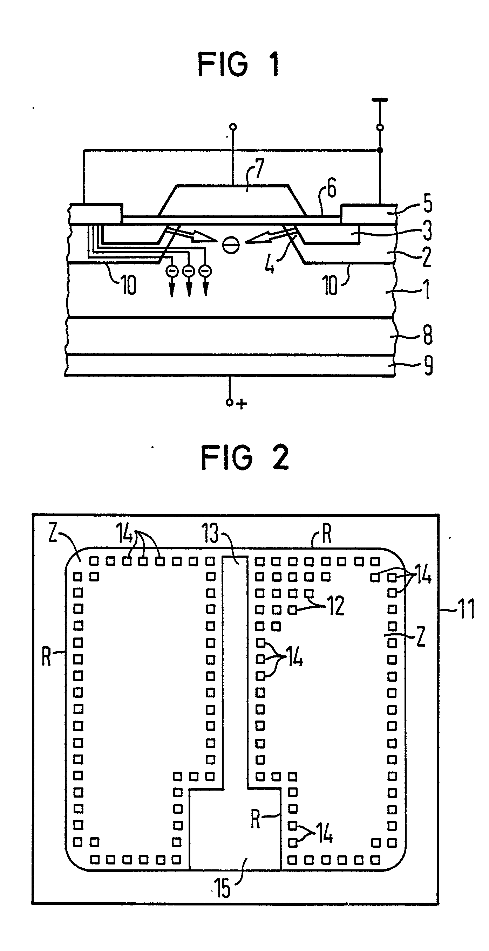

Der MIS-Leistungstransistors nach Figur 1 hat eine erste Zone 1 vom ersten Leitungstyp. In diese ist eine höher dotierte Zone 2 des entgegengesetzten Leitungstyps planar eingebettet. In die zweite Zone 2 ist eine dritte Zone des ersten Leitungstyps eingebettet, die höhere Dotierungskonzentration als die Zone 2 hat. Diese Zone 2, hat eine zwischen der Zone 1, der Drainzone und der Sourcezone 3 liegende Kanalzone 4. Die Zone 2 und die Sourcezone 3 sind von einer Sourceelektrode 5 gemeinsam kontaktiert. Auf der freien Oberfläche des Halbleiterkörpers liegt eine Isolierschicht 6, auf der eine Gateelektrode 7 angeordnet ist. Diese überdeckt die Kanalzone 4 und den an die Oberfläche tretenden Teil der Drainzone 1.

Drainseitig grenzt an die Drainzone 1 eine Zone 8 des gleichen Leitungstyps, jedoch höherer Dotierungskonzentration an. Die Drainzone ist durch eine Drainelektrode 9 kontaktiert.

Wird an den Transistor eine Sperrspannung angelegt, so baut sich am zwischen Drainzone 1 und Zone 2 liegenden pn-Übergang 10 eine Raumladungszone auf. Wird die Spannung gesteigert, so kommt es bei Erreichen der kritischen Feldstärke $E_{krit.}$ zum Avalanchedurchbruch. Die erzeugten negativen Ladungsträger fließen dann in die Drainzone, wobei sie im allgemeinen wegen der in der Zone 2 herrschenden Dotierstoffverteilung wie dargestellt waagrecht unter der Sourcezone 3 und dann zur Drainelektrode 9 abfließen.

Die negativen Ladungsträger erzeugen unter der Sourcezone 3 einen Spannungsabfall, der, übersteigt er 0,5 bis 0,7 Volt, die Sourcezone zur Ladungsträgeremission veranlaßt. Diese Ladungsträger bilden den Steuerstrom für einen aus den Zonen 3, 2 und 1 gebildeten parasitären Bipolartransistor. Wird der parasitäre Bipolartransistor eingeschaltet, so wird die Zelle zerstört und der ganze Transistor wird unbrauchbar.

Ein solcher Avalanchedurchbruch findet, wie oben erläutert, vorzugsweise am Rand des Halbleiterkörpers oder an sonstigen Inhomogenitäten auf dem Halbleiterkörper statt.

Die Aufsicht auf den Halbleiterkörper eines MIS-Leistungstransistors nach Figur 2 verdeutlicht, daß Inhomogenitäten auf dem Halbleiterkörper 11 hauptsächlich an denjenigen Zellen 14 auftreten, die am Rand R des Halbleiterkörpers liegen. Inhomogenitäten treten beispielsweise auch am Gatepad 15 und an einem Gatesteg 13 auf, die zur Kontaktierung der Gatezuleitung bzw. besseren Gatestromverteilung dienen. Im Beispiel nach Fig. 2 ist die Oberfläche des Halbleiterkörpers mit zwei Zellenfeldern bedeckt. Zwischen den einzelnen Zellenfelder besteht ein Abstand, der größer ist als der Abstand der einzelnen Zellen untereinander.

Erfindungsgemäß ist nun jedes Zellen eines ersten Zellentyps aufweisendes Zellenfeld Z von Zellen 14 eines zweiten Zellentyps umrandet.

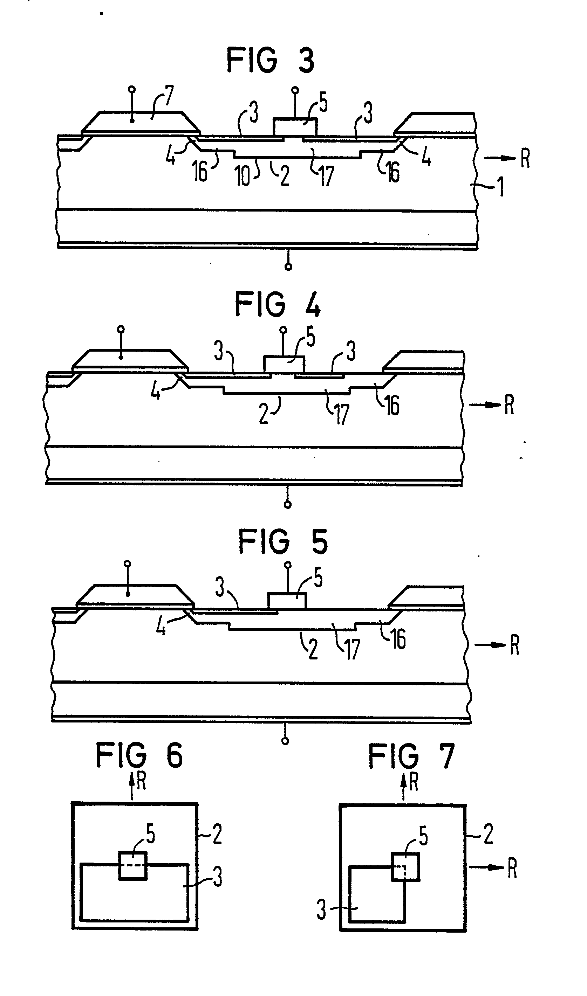

In Figur 3 ist eine Zelle des ersten Zellentyps dargestellt, die in Figur 2 mit 12 bezeichnet sind. Der Aufbau der Zelle nach Figur 3 entspricht im wesentlichen der nach Figur 1. Bei realen MIS-Leistungstransistoren hat die Zone 2 im allgemeinen zwei verschiedene Abschnitte 16 und 17. Der Bereich 16 ist dünner und niedriger dotiert als der Bereich 17. Der höher dotierte Bereich 17 dient hauptsächlich einer guten Kontaktierung der Gatezone 2. Die niedrigere Dotierung des Bereichs 16 hat den Zweck, die Einsatzspannung des Transistors niedrig zu halten. Der eingangs erwähnte parasitäre Bipolartransistor wird nun hauptsächlich durch die Sourcezone 3, den Bereich 16 und durch die Drainzone 1 gebildet.

In Figur 4 ist eine Zelle des zweiten Zellentyps dargestellt, die in Figur 2 mit 14 bezeichnet sind. Diese Zellen bilden mit den Zellen 12 jeweils ein Zellenfeld Z und umranden dieses. Da für das Einschalten des parasitären Bipolartransistors in erster Linie der laterale Spannungsabfall unter der Sourcezone verantwortlich ist, werden die lateralen Abmessungen der Sourcezone 3 zwischen der Sourceelektrode 5 und dem Rand R schmaler gemacht als bei einer Zelle des ersten Zellentyps. Wie klein die lateralen Abmessungen gemacht werden müssen, hängt bei gegebenem Avalanchestrom von der Dotierung der Zone 2 ab. Es ist jedoch auf jeden Fall empfehlenswert, die lateralen Abmessungen der Sourcezone 3 auf der erwähnten Seite so klein zu machen, daß der Bereich 16 der Zone 2 keine Sourcezone mehr aufweist und nur noch in den tieferen, höher dotierten Bereich 17 der Zone 2 eine verkleinerte Sourcezone 3 eingebettet ist. Auf der vom Rand R abgekehrten Seite der Zelle bzw. der Sourceelektrode 5 kann die Sourcezone die gleiche Größe haben wie in den Zellen des ersten Zellentyps.

Die Wirkung des parasitären Bipolartransistors läßt sich durch die Verwendung von Zellen eines dritten Zellentyps noch besser ausschalten, wenn die Zone 2 auf der zum Rand R gewandten Seite der Sourceelektrode 5 überhaupt nicht mehr vorhanden ist. Eine solche Zelle ist in Figur 5 gezeigt. Im allgemeinen dürfte es ausreichen, wenn die Zellen 14 die in Figur 6 in der Aufsicht gezeigte Gestalt haben. Hier hat die Sourcezone etwa die halbe Größe wie in einer normalen Zelle und ist auf der vom Rand R abgewandten Seite der Zelle bzw. der Sourceelektrode angeordnet. An der Ecke eines Zellenfeldes kann es sich empfehlen, eine Zelle 14 einzusetzen, deren Aufsicht in Figur 7 gezeigt ist. Hier hat die Sourcezone nur noch ein Viertel der Größe der Sourcezone einer normalen Zelle. Sie wird wieder auf der vom Rand R abgewandten Seite der Zone 2 angeordnet.

In extremen Fällen kann es sich auch empfehlen, die Sourcezonen in den das Zellenfeld umrandenden Zellen 14 völlig wegzulassen. Damit verringert sich allerdings die verfügbare Kanalbreite gegenüber der Lösung nach Figur 4 und 5 nochmals.

Ein Herstellung der Zellen nach Figur 4 und 5 ist auf einfache Weise dadurch möglich, daß diejenigen Bereiche, die keine Sourcezone aufweisen sollen, bei der Herstellung der Sorcezone z. b. Ionenimplantation durch eine Lackmaske, Oxidmaske, Nitridmaske oder Polysiliziummaske abgedeckt werden.

## Ansprüche

1. MIS-Leistungstransistor mit mindestens einem auf einem Halbleiterkörper angeordneten Zellenfeld, daß einander parallelgeschaltete, Zellen eines ersten Zellentyps enthält, die jeweils eine Zone, eine in diese Zone eingebettete Sourcezone und eine beide Zonen kontaktierende Sourceelektrode aufweisen,
**dadurch gekennzeichnet,** daß das Zellenfeld (Z) durch Zellen (14) eines zweiten Zellentyps umrandet ist, daß diese Zellen eine Zone (2) und eine Sourcezone (3) und eine die Zone (2) und die Sourcezone kontaktierende Elektrode (5) haben, daß die Sourcezone (3) zwischen der Elektrode und der zum Rand des Zellenfeldes gewandten Seite der Gatezone geringere laterale Abmessungen hat als die Sourcezone der Zellen (12) des ersten Zellentyps, und daß die Elektroden (5) der Zellen des zweiten Zellentyps mit den Sourceelektroden (5) der Zellen des ersten Zellentyps elektrisch verbunden sind.

2. MIS-Leistungstransistor nach Anspruch 1, **dadurch gekennzeichnet,** daß in die Zonen (2) der Zellen (14) des zweiten Zellentyps lediglich auf er zum Zellenfeld (Z) gewandten Seite der Sourceelektrode eine Sourcezone (3) eingebettet ist.

3. MIS-Leistungstransistor nach Anspruch 1, **dadurch gekennzeichnet,** daß das Zellenfeld durch Zellen eines dritten Zellentyps umrandet ist, daß diese Zellen nur Zonen (2), aber keine Sourcezonen aufweisen, daß die Zonen (2) jeweils mit einer Elektrode kontaktiert sind und daß die Elektroden mit den Sourceelektroden elektrisch verbunden sind.

4. MIS-Leistungstransistor nach einem der Ansprüche 1 bis 3,
**dadurch gekennzeichnet,** daß die Zonen (2) aller Zellentypen gleich ausgebildet sind.

# FIG 1

# FIG 2

EP 0 293 846 A1

FIG 3

FIG 4

FIG 5

FIG 6

FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 127 222 (RCA CORP.)<br>* Insgesamt *<br>--- | 1,2 | H 01 L 29/78<br>H 01 L 29/10 |
| A | EP-A-0 133 642 (K.K. TOSHIBA)<br>* Seite 5, Zeile 12 - Seite 10, Zeile 3; Figuren 5,7-10 *<br>--- | 1-3 | |
| A | PATENT ABSTRACTS OF JAPAN, Band 10, Nr. 259 (E-434)[2315], 4. September 1986; & JP-A-61 84 865 (NEC CORP.) 30-04-1986<br>* Zusammenfassung; Figuren *<br>--- | 1,2,4 | |
| A | DE-A-3 540 433 (MITSUBISHI DENKI K.K.)<br>* Zusammenfassung; Figur 6 *<br>----- | 1,3 | |

| | |
|---|---|
| | **RECHERCHIERTE SACHGEBIETE (Int. Cl.4)**<br><br>H 01 L |

Der vorliegende Recherchenbericht wurde für alle Patentansprüche erstellt

| Recherchenort | Abschlußdatum der Recherche | Prüfer |
|---|---|---|
| DEN HAAG | 08-09-1988 | BAILLET B.J.R. |

EPO FORM 1503 03.82 (P0403)